# EUROPEAN PATENT APPLICATION

(11) **EP 2 639 961 A1**
(43) Date of publication of application: **18.09.2013**
(21) Application number: 12162696.4
(22) Date of filing: 30.03.2012
(51) Int. Cl.: H03K 17/16, H02M 3/156

(54) **Power switch circuit**

(30) Priority: 16.03.2012 CN 201210069303
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Gao, Fu-Li, Shenzhen City, Guangdong Province (CN); Kao, Hsing-Suang, Tu-Cheng, New Taipei (TW)
(74) Representative: Gray, John James

(57) **Abstract**

A power switch circuit 10 includes a pulse width modulation (PWM) control circuit 11 having a first frequency control terminal DR1 and a second frequency control terminal DR2 for outputting predetermined frequency signals, a first switch circuit 12, a second switch circuit 13, a first resistor R1 connected between the first frequency control terminal and the first switch circuit, a second resistor R2 connected between the first frequency control terminal and the second switch circuit, a first filtering circuit 14 having a third resistor and a first capacitor, and a second filtering circuit 15 having a fourth resistor and a second capacitor. A first terminal of the first capacitor is connected to the first switch circuit and a second terminal of the first capacitor is grounded via the third resistor. A first terminal of the second capacitor is connected to the second switch circuit and a second terminal of the second capacitor is grounded via the fourth resistor.

## Description

### Field

The present disclosure relates to power switch circuits and, particularly, to a power switch circuit capable of reducing electromagnetic interference (EMI).

### BackGround

EMI effects performance of electronic devices greatly. For example, when power is supplied to a power switch circuit in an electronic device, power system harmonics may be created at the moment that a switch element of the power switch circuit is turned on causing EMI.

### Summary

According to one aspect of the disclosure, a related power switch circuit is provided. The related power switch includes a pulse width modulation (PWM) control circuit having a first frequency control terminal and a second frequency control terminal for outputting predetermined frequency signals, a first switch circuit, a second switch circuit, a first resistor connected between the first frequency control terminal and the first switch circuit, a second resistor connected between the first frequency control terminal and the second switch circuit, a first filtering circuit having a third resistor and a first capacitor, and a second filtering circuit having a fourth resistor and a second capacitor. A first terminal of the first capacitor is connected to the first switch circuit and a second terminal of the first capacitor is grounded via the third resistor. A first terminal of the second capacitor is connected to the second switch circuit and a second terminal of the second capacitor is grounded via the fourth resistor.

In the present disclosure, the power switch circuit 10 includes the first filtering circuit 14 and the second filtering circuit 15 connected between switch circuit and output port of the power switch circuit respectively. The first and second filtering circuits are capable of restricting amplitude of the higher harmonic when the PWM control circuit provides higher harmonics, which reduces electromagnetic interference of the power switch circuit 10.

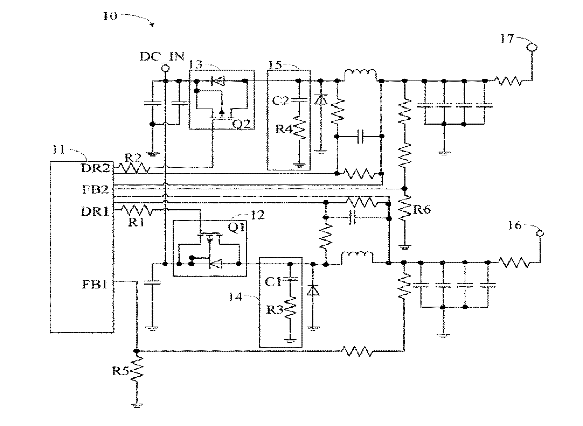

### BRIEF DESCRIPTION OF THE DRAWING

Embodiment of the invention is described, by way of example only, with reference to the accompanying drawing, in which:
The figure is a circuit diagram of a power switch circuit in accordance with an exemplary embodiment.

### DETAILED DESCRIPTION

Referring to the figure, a power switch circuit 10 includes a pulse-width modulation (PWM) control circuit 11, a first resistor R1, a second resistor R2, a first switch circuit 12, and a second switch circuit 13. The PWM control circuit 11 includes a first frequency control terminal DR1 and a second frequency control terminal DR2 configured for outputting predetermined frequency signals. A first terminal of the first resistor R1 is connected to the first frequency control terminal DR1, and a second terminal of the first resistor R1 is connected to the first switch circuit 12. A first terminal of the second resistor R2 is connected to the second frequency control terminal DR2, and a second terminal of the second resistor R2 is connected to the second switch circuit 13.

In the embodiment, the first switch circuit 12 includes a field effect transistor Q1, and the second switch circuit 13 includes a field effect transistor Q2. The second terminal of the first resistor R1 is connected to the grid of the field effect transistor Q1, the second terminal of the second resistor R2 is connected to the grid of the field effect transistor Q2. The drains of the field effect transistor Q1 and the field effect transistor Q2 are both connected to a power input port DC_IN.

The power switch circuit 10 further includes a first filtering circuit 14 and a second filtering circuit 15. The first filtering circuit 14 is connected between the first switch circuit 12 and a first output port 16 of the power switch circuit 10, and the second filtering circuit 15 is connected between the second switch circuit 13 and a second output port 17 of the power switch circuit 10. In the embodiment, the first filtering circuit 14 includes a third resistor R3 and a first capacitor C1. A first terminal of the first capacitor C1 is connected to the source of the field effect transistor Q1, and a second terminal of the first capacitor C1 is grounded via the third resistor R3. The second filtering circuit 15 includes a fourth resistor R4 and a second capacitor C2. A first terminal of the second capacitor C2 is connected to source of the field effect transistor Q2, and a second terminal of the second capacitor C2 is grounded via the fourth resistor R4.

In the embodiment, the PWM control circuit 11 is an integration circuit, and further includes a first feedback port FB1 grounded via a resistor R5 and a second feedback port FB2 grounded via a resistor R6. The first frequency control terminal DR1 is connected to the grid of the field effect transistor Q1, and the second frequency control terminal DR2 is connected to the grid of the field effect transistor Q2.

When the first frequency control terminal DR1 and the second frequency control terminal DR2 respectively output higher harmonics generated by the PWM control circuit 11, the first filtering circuit 14 and the second filtering circuit 15 are capable of restricting amplitude of the higher harmonics, thereby reducing electromagnetic interference of the power switch circuit 10.

In the embodiment, the power switch circuit 10 further includes other elements which are not related to the present disclosure and left out.

It should be emphasized that the above-described embodiments of the present disclosure, particularly, any embodiments, are merely possible examples of implementations, merely set forth for a clear understanding of the principles of the disclosure. Many variations and modifications may be made to the above-described embodiment(s) of the disclosure without departing substantially from the spirit and principles of the disclosure. All such modifications and variations are intended to be included herein within the scope of this disclosure and the present disclosure and protected by the following claims.

## Claims

1. A power switch circuit, comprising:
a pulse width modulation (PWM) control circuit comprising a first frequency control terminal and a second frequency control terminal for outputting predetermined frequency signals;
a first switch circuit;
a second switch circuit;
a first resistor connected between the first frequency control terminal and the first switch circuit;
a second resistor connected between the first frequency control terminal and the second switch circuit;
a first filtering circuit comprising a third resistor and a first capacitor, wherein a first terminal of the first capacitor is connected to the first switch circuit and a second terminal of the first capacitor is grounded via the third resistor; and
a second filtering circuit comprising a fourth resistor and a second capacitor, wherein a first terminal of the second capacitor is connected to the second switch circuit and a second terminal of the second capacitor is grounded via the fourth resistor.

2. The power switch circuit as claimed in claim 1, wherein the first switch circuit comprises a first field effect transistor, and the second switch circuit comprises a second field effect transistor.

3. The power switch circuit as claimed in claim 2, wherein the second terminal of the first resistor is connected to the grid of the first field effect transistor, and the second terminal of the second resistor is connected to the grid of the second field effect transistor.

4. The power switch circuit as claimed in claim 2, wherein the first terminal of the first capacitor is connected to the source of the first field effect transistor, and the first terminal of the second capacitor is connected to the source of the second field effect transistor.
